(19) Europäisches Patentamt
European Patent Office
Office européen des brevets

(11) **EP 3 035 018 B1**

(12) **FASCICULE DE BREVET EUROPEEN**

(45) Date de publication et mention de la délivrance du brevet:
**18.10.2017 Bulletin 2017/42**

(51) Int Cl.:
**G01K 1/18** *(2006.01)*     **G01K 3/14** *(2006.01)*
**G01K 7/02** *(2006.01)*

(21) Numéro de dépôt: **15201741.4**

(22) Date de dépôt: **21.12.2015**

(54) **CAPTEUR DIFFERENTIEL DE TEMPERATURE**

DIFFERENZIELLER TEMPERATURSENSOR

DIFFERENTIAL TEMPERATURE SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2014 FR 1462975**

(43) Date de publication de la demande:
**22.06.2016 Bulletin 2016/25**

(73) Titulaires:
- **Commissariat à l'Energie Atomique et aux Energies Alternatives**
  **75015 Paris (FR)**
- **Hotblock Onboard**
  **38000 Grenoble (FR)**

(72) Inventeurs:
- **Savelli, Guillaume**
  **38180 Seyssins (FR)**
- **Dufourcq, Joël**
  **64270 Puyoo (FR)**

(74) Mandataire: **Talbot, Alexandre et al**
**Cabinet Hecké**
**Europole**
**10, rue d'Arménie - BP 1537**
**38025 Grenoble Cedex 1 (FR)**

(56) Documents cités:
EP-A2- 1 976 034     WO-A1-2013/007593
US-A1- 2006 076 046

## Description

### Domaine technique

La présente invention a trait à un capteur différentiel de température. Plus précisément, il s'agit d'un capteur thermoélectrique à effet Seebeck.

### Etat de la technique antérieure

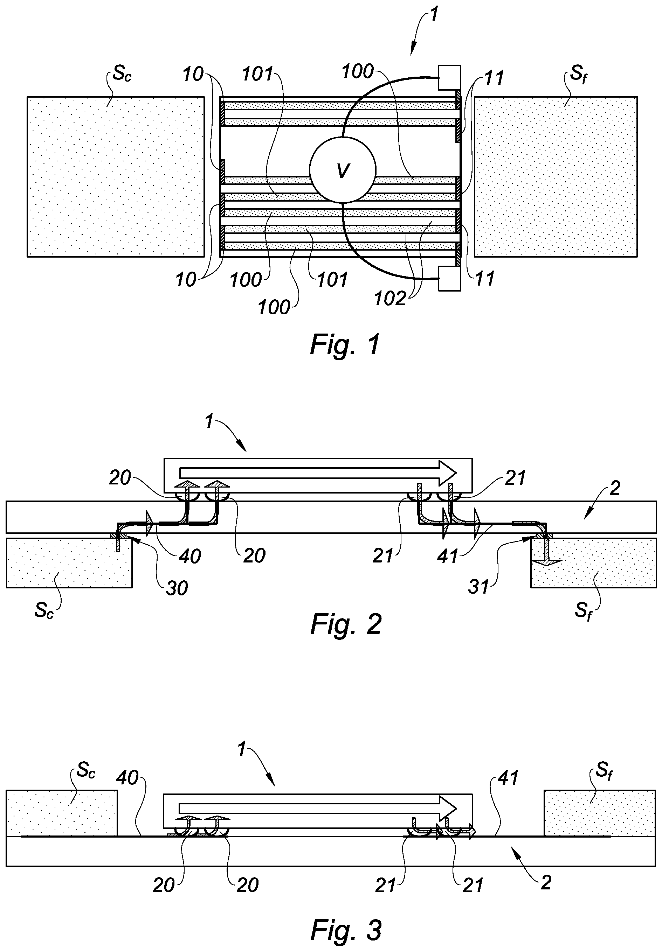

Comme illustré à la figure 1, un capteur 1 différentiel de température entre une source chaude Sc et une source froide Sf connu de l'état de la technique, comporte :

- un substrat (non visible), de préférence réalisé dans un matériau à base de silicium,
- un ensemble de couches thermoélectriques agencé sur le substrat séparées par un matériau thermiquement isolant 102, l'ensemble comprenant au moins une première jonction 10 d'un thermocouple 100, 101 sur un côté de l'ensemble, dit côté chaud, et au moins une deuxième jonction 11 du thermocouple 100, 101 sur le côté opposé de l'ensemble, dit côté froid,
- au moins un premier et un deuxième plots de connexion (non visibles) agencés pour transférer de la chaleur respectivement à chaque première jonction 10 et à chaque deuxième jonction 11.

Les termes « chaud(e) » et « froid(e) » s'entendent de manière relative, c'est-à-dire que la température de la source « chaude » est supérieure à la température de la source « froide ».

Les plots de connexion sont destinés à être connectés thermiquement à la source chaude Sc et à la source froide Sf.

L'ensemble de couches thermoélectriques comporte N thermocouples 100, 101, c'est-à-dire N couches réalisées à base d'un premier matériau thermoélectrique 100 et N couches réalisées à base d'un second matériau thermoélectrique 101. Chaque première jonction 10 et chaque deuxième jonction 11 sont formées avec un matériau électriquement conducteur.

La tension de sortie V générée par le capteur 1 est donnée par la formule suivante :

$$V = N \times (S_2 - S_1) \times (Tc - Tf),$$

où :

- N est le nombre de thermocouples 100, 101,
- $S_1$ et $S_2$ sont respectivement le coefficient Seebeck des premier et second matériaux thermoélectriques 100, 101,
- (Tc-Tf) est le gradient thermique appliqué entre le côté chaud et le côté froid de l'ensemble.

Un tel capteur 1 de l'état de la technique forme une puce, et s'inscrit dans les technologies couches minces, différant ainsi des capteurs thermoélectriques à effet Seebeck macroscopiques.

Par « puce », on entend une plaquette, de préférence en silicium, comportant un composant élémentaire.

Un tel capteur 1 de l'état de la technique est donc utilisé dans diverses applications où la miniaturisation est recherchée. On peut citer à titre d'exemples non limitatifs la microélectronique, la téléphonie mobile, la domotique (maison communicante individuelle « *Smart home* », bâtiment à énergie positive « *Smart building* », réseaux électriques intelligents *« Smart grid »*), certains procédés industriels.

Actuellement, pour réaliser une fonction électronique, l'intégration d'un tel capteur 1 à d'autres composants élémentaires dans un circuit s'effectue lors du procédé technologique de fabrication du circuit. Cette solution n'est pas satisfaisante car elle occasionne une complexité et de multiples contraintes pour l'exécution des étapes du procédé qui doivent tenir compte de l'influence des composants élémentaires adjacents.

En outre, l'intégration directe d'un tel capteur 1 dans un boîtier, par exemple un boîtier de circuit intégré, occasionne des pertes thermiques importantes qui affectent le gradient thermique appliqué entre le côté chaud et le côté froid de l'ensemble, empêchant ainsi le fonctionnement correct du capteur 1.

WO2013/007593 décrit un procédé de génération électrique au sein d'une structure intégrée tridimensionnelle.

### Exposé de l'invention

La présente invention vise à remédier en tout ou partie aux inconvénients précités, et concerne à cet effet un capteur différentiel de température entre une source chaude et une source froide, le capteur comportant :

- un substrat,
- un ensemble de couches thermoélectriques agencé sur le substrat, l'ensemble comprenant au moins une première jonction d'un thermocouple sur un côté de l'ensemble, dit côté chaud, et au moins une deuxième jonction du thermocouple sur le côté opposé de l'ensemble, dit côté froid,
- au moins un premier et un deuxième plots de connexion agencés pour transférer de la chaleur respectivement à chaque première jonction et à chaque deuxième jonction, le capteur étant remarquable en ce qu'il comporte :
- un organe de support thermiquement isolant agencé pour supporter le substrat, l'organe de support étant destiné à être connecté à la source chaude et à la source froide,

- des premiers et des deuxièmes moyens de connexion métalliques agencés pour connecter électriquement l'organe de support avec respectivement le ou chaque premier plot de connexion et le ou chaque deuxième plot de connexion, et en ce que l'organe de support comporte des moyens de transfert thermique agencés pour transférer la chaleur de la source chaude vers les premiers moyens de connexion métalliques, et pour transférer la chaleur des deuxièmes moyens de connexion métalliques vers la source froide.

La connexion de l'organe de support avec les sources chaude et froide peut être directe, c'est-à-dire que l'organe de support est en contact direct avec lesdites sources. La connexion peut-être indirecte, c'est-à-dire que l'organe de support est connecté thermiquement auxdites sources via un chemin thermique.

Ainsi, un tel capteur selon l'invention est intégré à l'organe de support grâce aux premiers et aux deuxièmes moyens de connexion métalliques. La nature métallique des premiers et deuxièmes moyens de connexion permet d'assurer à la fois :

- une connexion électrique de l'organe de support avec les plots de connexion,
- une bonne conduction thermique entre l'organe de support et les plots de connexion.

Par « thermiquement isolant », on entend que l'organe de support présente une conductivité thermique inférieure à une valeur de l'ordre de 150 W/m/K.

Par « thermiquement conducteur », on entend une entité présentant une conductivité thermique supérieure à une valeur de l'ordre de 150 W/m/K.

L'organe de support est thermiquement isolant de manière à éviter la formation d'un pont thermique entre les premiers et les deuxièmes moyens de connexion métalliques via l'organe de support. Ainsi, le gradient thermique entre la source chaude et la source froide peut être répercuté entre les premiers et les deuxièmes moyens de connexion métalliques, et par là-même entre le côté chaud et le côté froid de l'ensemble de couches thermoélectriques via le premier et le deuxième plots de connexion.

En outre, les pertes thermiques liées à l'intégration sont fortement réduites grâce aux moyens de transfert de chaleur de l'organe de support et aux premiers et aux deuxièmes moyens de connexion métalliques.

Selon un mode de réalisation, les premiers et les deuxièmes moyens de connexion métalliques comportent une bille de brasage brasée respectivement sur le ou chaque premier plot de connexion et sur le ou chaque deuxième plot de connexion de manière à assembler le substrat et l'organe de support.

Ainsi, de telles billes de brasage métalliques possèdent d'excellentes propriétés de conduction thermique.

Selon une variante d'exécution, les premiers et les deuxièmes moyens de connexion métalliques comportent un fil de câblage soudé respectivement sur le ou chaque premier plot de connexion et sur le ou chaque deuxième plot de connexion de manière à assembler le substrat et l'organe de support.

Selon un mode de réalisation, les moyens de transfert thermique comportent au moins une première et une deuxième broches de connexion métalliques destinées à être connectées respectivement à la source chaude et à la source froide.

Ainsi, de telles broches de connexion métalliques permettent d'assurer à la fois :

- une connexion électrique de l'organe de support avec par exemple une carte électronique,
- une bonne conduction thermique entre les sources chaude et froide et l'organe de support.

Selon un mode de réalisation, les moyens de transfert thermique comportent :

- au moins une première piste métallique reliant les premiers moyens de connexion à la ou chaque première broche de connexion métallique,
- au moins une deuxième piste métallique reliant les deuxièmes moyens de connexion à la ou chaque deuxième broche de connexion métallique.

Ainsi, de telles pistes métalliques peuvent être dessinées au sein de l'organe de support de manière à :

- éviter un pont thermique entre le côté chaud et le côté froid de l'ensemble,
- assurer une connexion électrique,
- assurer une bonne conduction thermique entre les broches de connexion métalliques et les moyens de connexion correspondants.
- maintenir une bonne tenue mécanique des pistes.

Selon une forme d'exécution, le capteur comporte un boîtier de circuit intégré renfermant l'ensemble de couches thermoélectriques, ledit boîtier comportant l'organe de support.

Ainsi, un tel capteur selon l'invention est intégré directement au boîtier de circuit intégré. En outre, un boîtier de circuit intégré comporte classiquement des broches de connexion métalliques pouvant être connectées à la source chaude et à la source froide. Par ailleurs, un boîtier de circuit intégré permet d'encapsuler l'ensemble de couches thermoélectriques.

Dans un mode de réalisation, le capteur comporte un boîtier additionnel renfermant le boîtier de circuit intégré, le boîtier additionnel comprenant :

- une première face et une deuxième face opposée, de préférence revêtues d'un matériau thermiquement conducteur, les première et deuxième faces étant destinées à être respectivement connectées à la source chaude et à la source froide,

- un premier via, de préférence métallique, reliant la première face à chaque première broche de connexion,
- un deuxième via, de préférence métallique, reliant la deuxième face à chaque deuxième broche de connexion.

Des capteurs planaires non intégrés pouvant effectuer des mesures de température d'un flux orthogonal au substrat sont connus de l'état de la technique, notamment des documents WO 2007034048, FR 2955708, WO 8402037 et FR 2598803. Ainsi, un tel boîtier additionnel selon l'invention autorise la mesure de température lorsque les sources chaude et froide sont agencées de part et d'autre du boîtier de circuit intégré dans un plan orthogonal au substrat, et ce tout en conservant une puce-capteur intégrée. L'épaisseur et les première et deuxième faces du boîtier additionnel sont adaptées à la distance séparant les sources chaude et froide, les dimensions du boîtier de circuit intégré pouvant alors être fixes. Les faces rendues thermiquement conductrices et les vias transfèrent la chaleur entre les sources chaude et froide et le boîtier de circuit intégré.

Avantageusement, le boîtier additionnel comporte un organe de support agencé pour supporter le boîtier de circuit intégré.

Ainsi, l'organe de support du boîtier additionnel permet d'améliorer la tenue mécanique du capteur.

Avantageusement, le boîtier de circuit intégré comporte au moins une broche de connexion électrique, et le boîtier additionnel comporte au moins une piste électrique s'étendant à partir de la broche de connexion électrique.

Ainsi, une telle piste électrique permet de définir une sortie électrique pour le boîtier additionnel.

Selon une variante d'exécution, le capteur comporte une couche d'encapsulation agencée sur l'organe de support de manière à encapsuler l'ensemble de couches thermoélectriques, la couche d'encapsulation étant de préférence réalisée dans un matériau à base d'un polymère.

Avantageusement, l'ensemble de couches thermoélectriques présente une surface libre, et le capteur comporte un premier et un deuxième éléments thermiquement conducteurs s'étendant en regard et à distance de ladite surface libre, et dans le prolongement respectivement du côté chaud et du côté froid dudit ensemble.

Ainsi, de tels éléments thermiquement conducteurs permettent d'homogénéiser le transfert de chaleur entre le côté chaud et le côté froid de l'ensemble de couches thermoélectriques.

Avantageusement, le capteur comporte une couche diélectrique interposée entre le substrat et l'ensemble de couches thermoélectriques.

Ainsi, une telle couche diélectrique permet d'isoler électriquement et thermiquement le substrat.

Selon une forme d'exécution, le substrat est réalisé dans un matériau à base de silicium.

Selon une variante d'exécution, le substrat est réalisé dans un matériau thermiquement isolant, tel que le verre ou le quartz.

**Brève description des dessins**

D'autres caractéristiques et avantages apparaîtront dans la description qui va suivre de différents modes de réalisation d'un capteur selon l'invention, donnés à titre d'exemples non limitatifs, en référence aux dessins annexés dans lesquels :

- la figure 1 est une vue schématique de dessus d'un capteur de l'état de la technique (déjà commentée),
- les figures 2 à 7 sont des vues schématiques de côté d'un capteur selon différents modes de réalisation de l'invention,
- la figure 8 est une vue schématique de dessus d'un capteur selon un mode de réalisation de l'invention,
- la figure 9 est une vue schématique partielle de côté du mode de réalisation illustré à la figure 8,
- les figures 10 et 11 sont des vues schématiques de dessus d'un capteur selon l'invention illustrant deux types de connexion aux sources chaude et froide,
- la figure 12 est une vue schématique de côté d'un capteur selon un mode de réalisation de l'invention,
- la figure 13 est une vue schématique en perspective d'un boîtier de circuit intégré pouvant intégrer un capteur selon l'invention,
- la figure 14 est une vue schématique en perspective du boîtier retourné illustré à la figure 13,
- la figure 15 est une vue schématique de côté d'un capteur selon un mode de réalisation de l'invention,
- la figure 16 est une vue schématique de côté d'un capteur selon un mode de réalisation de l'invention.

Pour les différents modes de réalisation, les mêmes références seront utilisées pour des éléments identiques ou assurant la même fonction, par souci de simplification de la description.

**Exposé détaillé des modes de réalisation**

Aux figures 2 à 12 est illustré un capteur 1 différentiel de température entre une source chaude Sc et une source froide Sf, le capteur 1 comportant :

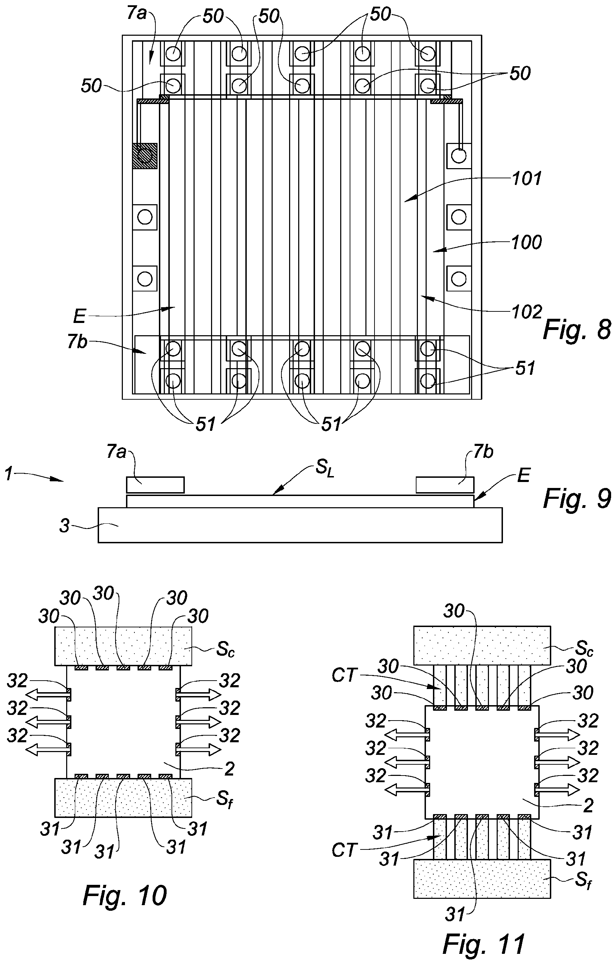

- un substrat 3 (visible à la figure 9),
- un ensemble E de couches thermoélectriques 100, 101 agencé sur le substrat 3 (l'ensemble E et le substrat 3 étant représentés schématiquement par un rectangle aux figures 2 à 7), l'ensemble E comprenant au moins une première jonction d'un thermocouple 100, 101 sur un côté de l'ensemble E, dit côté chaud, et au moins une deuxième jonction du thermocouple 100, 101 sur le côté opposé de l'ensemble E, dit côté froid, les couches thermoélectriques 100, 101 étant séparées par un matériau thermiquement isolant 102,

- au moins un premier et un deuxième plots de connexion 50, 51 agencés pour transférer de la chaleur respectivement à chaque première jonction et à chaque deuxième jonction.

Les termes « chaud(e) » et « froid(e) » s'entendent de manière relative, c'est-à-dire que la température de la source « chaude » est supérieure à la température de la source « froide ».

Un tel capteur 1 forme une puce c'est-à-dire une plaquette formant substrat, de préférence dans un matériau à base de silicium, comportant un composant élémentaire.

Par la suite, la structure formée par le substrat 3, l'ensemble E de couches thermoélectriques et les plots de connexion 50, 51 sera appelée « puce-capteur ».

Le substrat 3 est avantageusement plan. Le substrat 3 présente avantageusement une épaisseur comprise entre 100 et 200 $\mu$m afin de limiter le transfert de chaleur vers le substrat 3. En outre, on appelle « première direction » la direction s'étendant suivant l'épaisseur du substrat 3.

L'ensemble de couches thermoélectriques comporte N thermocouples 100, 101, c'est-à-dire N couches réalisées à base d'un premier matériau thermoélectrique 100 et N couches réalisées à base d'un second matériau thermoélectrique 101. Le premier matériau thermoélectrique 100 est avantageusement dopé électriquement selon un premier type de conductivité. Le second matériau thermoélectrique 101 est avantageusement dopé selon un second type de conductivité. Chaque première jonction 10 et chaque deuxième jonction 11 sont formées avec un matériau électriquement conducteur. Les N thermocouples 100, 101 et le matériau thermiquement isolant 102 sont juxtaposés suivant une direction perpendiculaire à la première direction.

Le capteur 1 comporte un organe de support 2 agencé pour supporter le substrat. L'organe de support 2 est destiné à être connecté directement ou indirectement à la source chaude Sc et à la source froide Sf. L'organe de support 2 est réalisé dans un matériau thermiquement isolant.

Le capteur 1 comporte des premiers et des deuxièmes moyens de connexion métalliques agencés pour connecter électriquement l'organe de support 2 avec respectivement le ou chaque premier plot de connexion 50 et le ou chaque deuxième plot de connexion 51.

L'organe de support 2 comporte des moyens de transfert thermique agencés pour transférer la chaleur de la source chaude Sc vers les premiers moyens de connexion métalliques, et pour transférer la chaleur des deuxièmes moyens de connexion métalliques vers la source froide Sf.

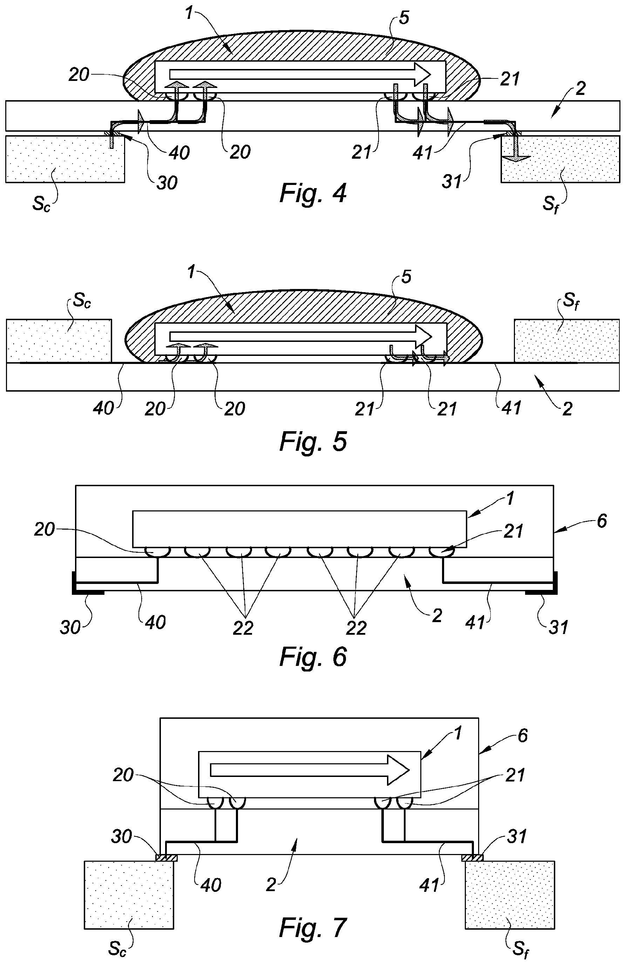

Dans un mode de réalisation, les premiers moyens de connexion métalliques comportent une bille de brasage 20 brasée sur chaque premier plot de connexion 50. Les deuxièmes moyens de connexion métalliques comportent une bille de brasage 21 brasée sur chaque deuxième plot de connexion 51. Les billes de brasage 20, 21 permettent en outre d'assembler le substrat 3 et l'organe de support 2. A cet effet, le capteur 1 peut comporter des billes de brasage additionnelles 22 (visibles à la figure 6) qui ne sont pas connectées électriquement aux plots de connexion 50, 51 mais contribuent à assembler le substrat 3 avec l'organe de support 2 pour améliorer la tenue mécanique. Les billes de brasage 20, 21, 22 sont de préférence réalisées à base d'un matériau sélectionné dans le groupe comportant Au, SnAgAu, SnAgCu. Les billes de brasage 20, 21, 22 présentent avantageusement un diamètre de l'ordre de 80 $\mu$m pour une épaisseur de l'ordre de 80 $\mu$m. De telles dimensions permettent d'associer compacité et surface de transfert thermique suffisante pour la fonctionnalité du capteur 1. Bien entendu, le diamètre et l'épaisseur des billes de brasage 20, 21, 22 peuvent varier, par exemple entre quelques dizaines et quelques centaines de microns.

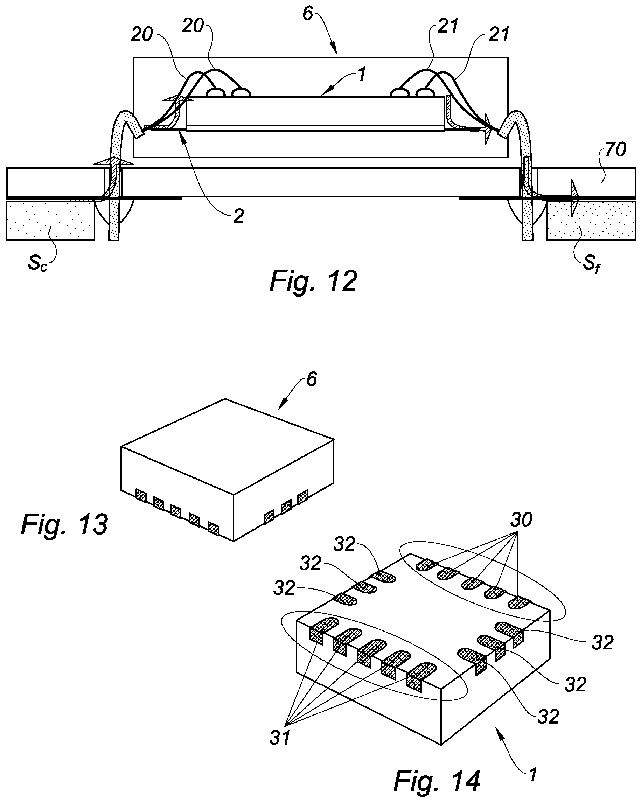

Dans une variante de réalisation illustrée à la figure 12, les premiers et les deuxièmes moyens de connexion métalliques comportent un fil de câblage 20, 21 soudé respectivement sur chaque premier plot de connexion 50 et sur chaque deuxième plot de connexion 51 de manière à assembler le substrat 3 et l'organe de support 2.

Dans un mode de réalisation, les moyens de transfert thermique comportent :

- des premières broches de connexion 30 métalliques connectées à la source chaude Sc,
- des deuxièmes broches de connexion 31 métalliques connectées à la source froide Sf.

La source chaude Sc et la source froide Sf peuvent être agencées sur l'organe de support 2 (figures 3 et 5). La source chaude Sc et la source froide Sf peuvent être agencées sous l'organe de support 2 (figures 2 et 4).

Dans un mode de réalisation, les moyens de transfert thermique comportent en outre :

- des premières pistes métalliques 40 reliant les billes de brasage 20 aux premières broches de connexion 30,
- des deuxièmes pistes métalliques 41 reliant les billes de brasage 21 aux deuxièmes broches de connexion 31.

Les flèches indiquent le sens du transfert de la chaleur au sein du capteur 1. Les pistes métalliques 40, 41 peuvent être ménagées à la surface de l'organe de support 2 lorsque la source chaude Sc et la source froide Sf sont agencées sur l'organe de support 2 (figures 3 et 5). Les pistes métalliques 40, 41 peuvent être ménagées à travers l'organe de support 2 lorsque la source chaude Sc et la source froide Sf sont agencées sous l'organe de support 2 (figures 2 et 4). De telles pistes métalliques 40, 41 sont dessinées au sein de l'organe de support 2 de manière à :

- éviter un pont thermique entre le côté chaud et le côté froid de l'ensemble E,
- assurer une connexion électrique,
- assurer une bonne connexion thermique entre les broches de connexion 30, 31 et les billes de brasage 20, 21,
- maintenir une bonne tenue mécanique des pistes.

Pour ce faire, à titre d'exemple non limitatif, de telles pistes métalliques 40, 41 présentent une épaisseur de l'ordre de quelques dizaines de nm pour une épaisseur de l'organe de support 2 de l'ordre de 100 nm.

Dans les modes de réalisation illustrés aux figures 2 à 5, l'organe de support 2 peut être un substrat de report adapté pour reporter la puce-capteur. Comme illustré aux figures 4 et 5, la puce-capteur peut être encapsulée à l'aide d'une couche d'encapsulation 5 agencée sur l'organe de support 2 de manière à encapsuler l'ensemble E. La couche d'encapsulation 5 est réalisée à base d'un matériau thermiquement isolant. La couche d'encapsulation 5 est de préférence réalisée dans un matériau à base d'un polymère.

Dans un mode de réalisation illustré notamment aux figures 6 et 7, l'organe de support 2 appartient à un boîtier 6 de circuit intégré. Les premières et deuxièmes broches de connexion 30, 31 équipent le boîtier 6. A titre d'exemple non limitatif, le boîtier 6 peut être de type SMD (*Surface Mounted Device*). Le boîtier 6 est de préférence réalisé dans un matériau isolant thermiquement. Le boîtier 6 présente de préférence une épaisseur comprise entre 0,1 et quelques mm. Le boîtier 6 ne présente pas de préférence de surface métallique centrale utilisée classiquement comme dissipateur de chaleur afin de ne pas nuire au transfert thermique entre le boîtier 6 et la puce-capteur.

Comme illustré à la figure 14, le boîtier 6 comporte :

- une rangée de premières broches de connexion 30 métalliques destinées à être connectées à la source chaude Sc, et reliées aux premières pistes métalliques 40,
- une rangée de deuxièmes broches de connexion 31 métalliques destinées à être connectées à la source froide Sf, et reliées aux deuxièmes pistes métalliques 41.

Les rangées de broches de connexion 30, 31 peuvent être continues de manière à former des barrettes.

La connexion peut être directe, c'est-à-dire que les broches de connexion 30, 31 sont respectivement en contact direct avec la source chaude Sc et la source froide Sf. La connexion peut-être indirecte, c'est-à-dire que les broches de connexion 30, 31 sont connectées thermiquement auxdites sources via un chemin thermique CT.

Les premières broches de connexion 30 forment des moyens de transfert thermique agencés pour transférer la chaleur de la source chaude Sc vers les premières pistes métalliques 40. Les deuxièmes broches de connexion 31 forment des moyens de transfert thermique agencés pour transférer la chaleur des deuxièmes pistes métalliques 41 vers la source froide Sf.

Le boîtier 6 comporte des rangées de broches de connexion 32 métalliques additionnelles qui ne sont pas utilisées comme moyens de transfert thermique. Les broches de connexion 32 métalliques additionnelles sont utilisées comme de simples connecteurs électriques. La puce-capteur peut comporter des plots de connexion électrique connectés électriquement à chaque première jonction et à chaque deuxième jonction. Les broches de connexion 32 peuvent être connectées électriquement auxdits plots de connexion électrique. L'homme du métier peut choisir différents agencements pour les broches de connexion 30, 31 utilisées comme moyens de transfert thermique, et pour les broches de connexion 32 utilisées comme connecteurs électriques. Ces différents agencements seront choisis notamment en fonction de l'application envisagée, du positionnement des sources chaude et froide Sc, Sf, et des connectiques pour l'intégration de la puce-capteur. Il est également possible d'utiliser au moins une broche de connexion métallique à la fois comme connecteur électrique et comme moyen de transfert thermique.

Le substrat 3 et l'organe de support 2 appartenant au boîtier 6 sont avantageusement assemblés par le procédé de la puce retournée (*Flip-Chip* en langue anglaise), connu de l'homme du métier, lorsque les moyens de connexion métalliques comportent des billes de brasage 20, 21, 22.

Le substrat 3 et l'organe de support 2 appartenant au boîtier 6 sont avantageusement assemblés par le procédé de câblage par fil (*Wire bonding* en langue anglaise), connu de l'homme du métier, lorsque les moyens de connexion métalliques comportent des fils de câblage 20, 21 soudés (figure 12).

Comme illustré à la figure 12, le boîtier 6 peut être relié à une carte électronique 70, par exemple de type SMI (Substrat Métallique Isolé). Les sources chaude et froide Sc, Sf sont agencées à l'arrière de la carte électronique 70 et sont connectées thermiquement aux fils de câblage 20, 21 soudés.

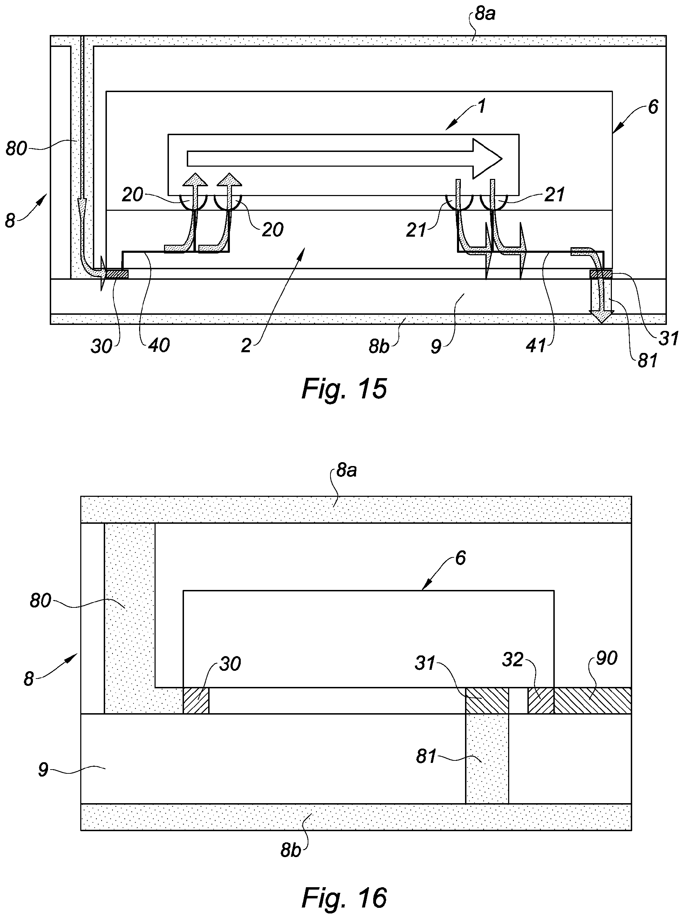

Dans un mode de réalisation illustré aux figures 15 et 16, le capteur 1 comporte un boîtier additionnel 8 renfermant le boîtier 6 de circuit intégré, le boîtier additionnel 8 comprenant :

- une première face 8a et une deuxième face 8b opposée, avantageusement revêtues d'un matériau thermiquement conducteur, et destinées à être respectivement connectées à la source chaude Sc et à la source froide Sf,
- un premier via 80, de préférence métallique, reliant la première face 8a à chaque première broche de connexion 30,
- un deuxième via 81, de préférence métallique, reliant la deuxième face 8b à chaque deuxième broche de connexion 31.

Le boîtier additionnel 8 est réalisé avantageusement dans un matériau thermiquement isolant. Les faces 8a, 8b sont rendues thermiquement conductrices de préférence au moyen d'un revêtement à base d'un matériau thermiquement conducteur. Le matériau thermiquement conducteur du revêtement peut être un métal tel que Cu, Au, Ag, ou un alliage à base d'argent, ou un matériau sélectionné dans le groupe comportant SiC, AlN, Al anodisé. Le matériau thermiquement conducteur du revêtement peut être déposé sur le boîtier additionnel 8 selon différentes techniques telles que le dépôt chimique en phase vapeur (CVD) ou le dépôt physique en phase vapeur (PVD). Le matériau thermiquement conducteur du revêtement peut être soudé ou brasé directement sur le boîtier additionnel 8.

Les vias 80, 81 peuvent avoir différentes formes. Les vias 80, 81 peuvent être monobloc ou formés en plusieurs puits. Les vias 80, 81 peuvent être reliés directement aux broches de connexion 30, 31 ou indirectement par l'intermédiaire de pistes métalliques.

Le boîtier additionnel 8 comporte avantageusement un organe de support 9 agencé pour supporter le boîtier 6 de circuit intégré à l'intérieur du boîtier additionnel 8. Le boîtier 6 de circuit intégré est avantageusement fixé à l'organe de support 9 du boîtier additionnel 8 par collage, brasure ou soudure. L'organe de support 9 du boîtier additionnel 8 comporte des orifices ménagés en son sein pour recevoir les deuxièmes via 81. Le boîtier additionnel 8 est réalisé avantageusement dans un matériau thermiquement isolant de manière à éviter la formation d'un pont thermique entre le premier via 80 et le deuxième via 81 par l'intermédiaire de l'organe de support 9 du boîtier additionnel 8. Ainsi, le gradient thermique entre la source chaude Sc et la source froide Sf peut être répercuté entre chaque première broche de connexion 30 et chaque deuxième broche de connexion 31, et par là-même entre le côté chaud et le côté froid de l'ensemble E de couches thermoélectriques. L'enceinte délimitée par le boîtier additionnel 8 peut être avantageusement mise sous vide afin de concentrer le transfert de chaleur sur les vias 80, 81.

Le premier via 80 pouvant être à proximité de la source froide Sf, il est nécessaire de configurer correctement géométriquement le premier via 80 ainsi que l'organe de support 9 du boîtier additionnel 8. Pour ce faire, l'équation ci-après doit être vérifiée :

$$\phi = \frac{e_{supp} \times \lambda_{via} \times S_{via}}{\lambda_{supp} \times S_{supp} \times e_{via}} \gg 1$$

où :

- $e_{supp}$ est l'épaisseur de l'organe de support 9 du boîtier additionnel 8,
- $e_{via}$ est l'épaisseur du premier via 80,
- $\lambda_{supp}$ est la conductivité thermique de l'organe de support 9 du boîtier additionnel 8,
- $\lambda_{via}$ est la conductivité thermique du premier via 80,
- $S_{supp}$ est la surface latérale de conduction thermique de l'organe de support 9 du boîtier additionnel 8,
- $S_{via}$ est la surface latérale de conduction thermique du premier via 80.

Par « latérale », on entend une direction parallèle à la première direction, c'est-à-dire la direction s'étendant suivant l'épaisseur du substrat 3.

A titre d'exemple non limitatif, le tableau ci-après rassemble des paramètres permettant de configurer correctement géométriquement le premier via 80 ainsi que l'organe de support 9 du boîtier additionnel 8 :

| Paramètre | |
|---|---|
| $e_{supp}$ | 200 $\mu$m |
| $e_{via}$ | 700 $\mu$m |
| $\lambda_{supp}$ | 0,2 W/m/K (résine epoxy) |
| $\lambda_{via}$ | 386 W/m/K (Cu) |
| $S_{supp}$ | 5x5 mm$^2$ |
| $S_{via}$ | 3x1 mm$^2$ |
| $\Phi$ | 66 |

Le boîtier 6 de circuit intégré comporte avantageusement au moins une broche de connexion 32 électrique qui n'est pas utilisée comme moyens de transfert thermique. Le boîtier additionnel 8 comporte avantageusement au moins une piste électrique 90 s'étendant à partir de la broche de connexion 32 électrique. L'homme du métier peut choisir différents agencements pour les broches de connexion 32 électrique notamment en fonction de l'application envisagée, du positionnement des sources chaude et froide Sc, Sf. Ainsi, l'homme du métier peut choisir différents agencements pour les pistes électriques 90 en fonction des agencements desdites broches de connexion 32 électriques afin de définir différentes positions de sorties électriques pour le boîtier additionnel 8. La ou chaque piste électrique 90 est avantageusement ménagée dans l'organe de support 9 du boîtier additionnel 8.

Dans le mode de réalisation illustré aux figures 8 et 9, l'ensemble E de couches thermoélectriques présente une surface libre $S_L$, le capteur comporte un premier et un deuxième éléments thermiquement conducteurs 7a, 7b s'étendant en regard et à distance de ladite surface libre $S_L$, et dans le prolongement respectivement du côté chaud et du côté froid dudit ensemble E. Autrement dit, les premier et deuxième éléments thermiquement conducteurs 7a, 7b surmontent des zones latérales de la surface libre $S_L$ sans contact direct. Les premier et deuxième éléments thermiquement conducteurs 7a, 7b peuvent être réalisés dans tout matériau thermiquement conducteur, comme décrit dans le document WO 2011012586. Les premier et deuxième éléments thermiquement conducteurs 7a, 7b sont avantageusement métalliques. Les premier et deuxième éléments thermiquement conducteurs 7a, 7b sont avantageusement réalisés sous la forme d'une bande métallique.

Dans un mode de réalisation, le capteur 1 comporte une couche diélectrique interposée entre le substrat 3 et l'ensemble E de couches thermoélectriques. Lorsque le substrat 3 est réalisé dans un matériau à base de silicium, la couche diélectrique est avantageusement du $SiO_2$ ou du $Si_3N_4$. La couche diélectrique présente une épaisseur comprise entre quelques nm et plusieurs centaines de $\mu$m.

## Revendications

1. Capteur (1) différentiel de température entre une source chaude (Sc) et une source froide (Sf), le capteur (1) comportant:

   - un substrat (3),
   - un ensemble (E) de couches thermoélectriques agencé sur le substrat (3), l'ensemble (E) comprenant au moins une première jonction d'un thermocouple (100, 101) sur un côté de l'ensemble (E), dit côté chaud, et au moins une deuxième jonction du thermocouple (100, 101) sur le côté opposé de l'ensemble (E), dit côté froid,
   - au moins un premier et un deuxième plots de connexion (50, 51) agencés pour transférer de la chaleur respectivement à chaque première jonction et à chaque deuxième jonction,
   - un organe de support (2) thermiquement isolant agencé pour supporter le substrat (3), l'organe de support (2) étant destiné à être connecté à la source chaude (Sc) et à la source froide (Sf),
   - des premiers et des deuxièmes moyens de connexion métalliques agencés pour connecter électriquement l'organe de support (2) avec respectivement le ou chaque premier plot de connexion (50) et le ou chaque deuxième plot de connexion (51), et **caractérisé en ce que** l'organe de support (2) comporte des moyens de transfert thermique agencés pour transférer la chaleur de la source chaude (Sc) vers les premiers moyens de connexion métalliques, et pour transférer la chaleur des deuxièmes moyens de connexion métalliques vers la source froide (Sf).

2. Capteur (1) selon la revendication 1, **caractérisé en ce que** les premiers et les deuxièmes moyens de connexion métalliques comportent une bille de brasage (20, 21) brasée respectivement sur le ou chaque premier plot de connexion (50) et sur le ou chaque deuxième plot de connexion (51) de manière à assembler le substrat (3) et l'organe de support (2).

3. Capteur (1) selon la revendication 1, **caractérisé en ce que** les premiers et les deuxièmes moyens de connexion métalliques comportent un fil de câblage (20, 21) soudé respectivement sur le ou chaque premier plot de connexion (50) et sur le ou chaque deuxième plot de connexion (51) de manière à assembler le substrat (3) et l'organe de support (2).

4. Capteur (1) selon l'une des revendications 1 à 3, **caractérisé en ce que** les moyens de transfert thermique comportent au moins une première et une deuxième broches de connexion (30, 31) métalliques destinées à être connectées respectivement à la source chaude (Sc) et à la source froide (Sf).

5. Capteur (1) selon la revendication 4, **caractérisé en ce que** les moyens de transfert thermique comportent :

   - au moins une première piste métallique (40) reliant les premiers moyens de connexion à la ou chaque première broche de connexion (30) métallique,
   - au moins une deuxième piste métallique (41) reliant les deuxièmes moyens de connexion à la ou chaque deuxième broche de connexion (31) métallique.

6. Capteur (1) selon l'une des revendications 1 à 5, **caractérisé en ce qu'**il comporte un boîtier (6) de circuit intégré renfermant l'ensemble (E) de couches thermoélectriques, ledit boîtier (6) comportant l'organe de support (2).

7. Capteur (1) selon la revendication 6 en combinaison avec la revendication 4, **caractérisé en ce qu'**il comporte un boîtier additionnel (8) renfermant le boîtier (6) de circuit intégré, le boîtier additionnel (8) comprenant :

   - une première face (8a) et une deuxième face (8b) opposée, de préférence revêtues d'un matériau thermiquement conducteur, les première et deuxième faces (8a, 8b) étant destinées à être respectivement connectées à la source chaude (Sc) et à la source froide (Sf),

- un premier via (80), de préférence métallique, reliant la première face (8a) à chaque première broche de connexion (30),

- un deuxième via (81), de préférence métallique, reliant la deuxième face (8b) à chaque deuxième broche de connexion (31).

8. Capteur (1) selon la revendication 7, **caractérisé en ce que** le boîtier additionnel (8) comporte un organe de support (9) agencé pour supporter le boîtier (6) de circuit intégré.

9. Capteur (1) selon la revendication 7 ou 8, **caractérisé en ce que** le boîtier (6) de circuit intégré comporte au moins une broche de connexion (32) électrique, et **en ce que** le boîtier additionnel (8) comporte au moins une piste électrique (90) s'étendant à partir de la broche de connexion (32) électrique.

10. Capteur (1) selon l'une des revendications 1 à 5, **caractérisé en ce qu'**il comporte une couche d'encapsulation (5) agencée sur l'organe de support (2) de manière à encapsuler l'ensemble (E) de couches thermoélectriques, la couche d'encapsulation (5) étant de préférence réalisée dans un matériau à base d'un polymère.

11. Capteur (1) selon l'une des revendications 1 à 10, **caractérisé en ce que** l'ensemble (E) de couches thermoélectriques présente une surface libre ($S_L$), et **en ce que** le capteur (1) comporte un premier et un deuxième éléments thermiquement conducteurs (7a, 7b) s'étendant en regard et à distance de ladite surface libre ($S_L$), et dans le prolongement respectivement du côté chaud et du côté froid dudit ensemble (E).

12. Capteur (1) selon l'une des revendications 1 à 11, **caractérisé en ce qu'**il comporte une couche diélectrique interposée entre le substrat (3) et l'ensemble (E) de couches thermoélectriques.

**Patentansprüche**

1. Differenzieller Temperatursensor (1) zwischen einer heißen Quelle (Sc) und einer kalten Quelle (Sf), wobei der Sensor (1) Folgendes umfasst:

- ein Substrat (3),
- eine Einheit (E) aus thermoelektrischen Schichten, die auf dem Substrat (3) angeordnet sind, wobei die Einheit (E) mindestens einen ersten Anschluss eines Thermoelementes (100, 101) auf einer Seite der Einheit (E), nämlich der heißen Seite, und mindestens einen zweiten Anschluss des Thermoelementes (100, 101) auf der der Einheit (E) gegenüberliegenden Seite, nämlich der kalten Seite, aufweist,
- mindestens eine erste und eine zweite Verbindungsstelle (50, 51), die zur Übertragung der Wärme zu jedem ersten Anschluss bzw. jedem zweiten Anschluss angeordnet sind,
- ein thermisch isolierendes Stützteil (2), das zum Abstützen des Substrats (3) angeordnet ist, wobei das Stützteil (29) zur Verbindung mit der heißen Quelle (Sc) und der kalten Quelle (Sf) vorgesehen ist,
- erste und zweite Metallverbindungsmittel, die zur elektrischen Verbindung des Stützteils (2) mit der oder jeder ersten Verbindungsstelle (50) bzw. der oder jeder zweiten Verbindungsstelle (51) angeordnet sind, und **dadurch gekennzeichnet, dass**

das Stützteil (2) Wärmeübertragungseinrichtungen umfasst, die zur Übertragung der Wärme von der heißen Quelle (Sc) auf die ersten Metallverbindungsmittel und zur Übertragung der Wärme von den zweiten Metallverbindungsmitteln auf die kalte Quelle (Sf) angeordnet ist.

2. Sensor (1) nach Anspruch 1, **dadurch gekennzeichnet, dass** die ersten und die zweiten Metallverbindungsmittel eine Lötkugel (20, 21) umfassen, die auf die oder jede erste Verbindungsstelle (50) bzw. auf die oder jede zweite Verbindungsstelle (51) derart aufgelötet ist, dass sie das Substrat (3) und das Stützteil (2) zusammenfügt.

3. Sensor (1) nach Anspruch 1, **dadurch gekennzeichnet, dass** die ersten und die zweiten Metallverbindungsmittel einen Kabeldraht (20, 21) umfassen, der auf die oder jede erste Verbindungsstelle (50) bzw. auf die oder jede zweite Verbindungsstelle (51) derart aufgeschweißt ist, dass er das Substrat (3) und das Stützteil (2) zusammenfügt.

4. Sensor (1) nach einem der Ansprüche 1 bis 3, **dadurch gekennzeichnet, dass** die Wärmeübertragungseinrichtungen mindestens einen ersten und einen zweiten Metallverbindungsstift (30, 31) umfassen, welche zur Verbindung mit der heißen Quelle (Sc) bzw. mit der kalten Quelle (Sf) vorgesehen sind.

5. Sensor (1) nach Anspruch 4, **dadurch gekennzeichnet, dass** die Wärmeübertragungseinrichtungen Folgendes aufweisen:

- mindestens einen ersten Metallstreifen (40), der die ersten Verbindungsmittel mit dem oder jedem ersten Metallverbindungsstift (30) verbindet,
- mindestens einen zweiten Metallstreifen (41), der die zweiten Verbindungsmittel mit dem oder jedem zweiten Metallverbindungsstift (31) verbindet.

**6.** Sensor (1) nach einem der Ansprüche 1 bis 5, **dadurch gekennzeichnet, dass** dieser ein integriertes Schaltungsgehäuse (6) aufweist, das die Einheit (E) aus thermoelektrischen Schichten enthält, wobei das Gehäuse (6) das Stützteil (2) aufweist.

**7.** Sensor (1) nach Anspruch 6 in Verbindung mit Anspruch 4, **dadurch gekennzeichnet, dass** dieser ein zusätzliches Gehäuse (8) aufweist, das das integrierte Schaltungsgehäuse (6) enthält, wobei das zusätzliche Gehäuse (8) Folgendes aufweist:

- eine erste Fläche (8a) und eine gegenüberliegende zweite Fläche (8b), welche vorzugsweise mit einem wärmeleitenden Material überzogen sind, wobei die erste und zweite Fläche (8a, 8b) dazu vorgesehen sind, dass sie mit der heißen Quelle (Sc) bzw. mit der kalten Quelle (Sf) verbunden werden,
- einen ersten Übergang (80), vorzugsweise aus Metall, der die erste Fläche (8a) mit jedem ersten Verbindungsstift (30) verbindet,
- einen zweiten Übergang (81), vorzugsweise aus Metall, der die zweite Fläche (8b) mit jedem zweiten Verbindungsstift (31) verbindet.

**8.** Sensor (1) nach Anspruch 7, **dadurch gekennzeichnet, dass** das zusätzliche Gehäuse (8) ein Stützteil (9) aufweist, das zum Abstützen des integrierten Schaltungsgehäuses (6) angeordnet ist.

**9.** Sensor (1) nach Anspruch 7 oder 8, **dadurch gekennzeichnet, dass** das integrierte Schaltungsgehäuse (6) mindestens einen elektrischen Verbindungsstift (32) umfasst, und dass das zusätzliche Gehäuse (8) mindestens einen elektrischen Streifen (90) umfasst, der sich ausgehend von dem elektrischen Verbindungsstift (32) weg erstreckt.

**10.** Sensor (1) nach einem der Ansprüche 1 bis 5, **dadurch gekennzeichnet, dass** dieser eine Verkapselungsschicht (5) umfasst, die auf dem Stützteil (2) derart angeordnet ist, dass sie die Einheit (E) aus thermoelektrischen Schichten einkapselt, wobei die Verkapselungsschicht (5) vorzugsweise aus einem Material auf der Basis eines Polymers hergestellt ist.

**11.** Sensor (1) nach einem der Ansprüche 1 bis 10, **dadurch gekennzeichnet, dass** die Einheit (E) aus thermoelektrischen Schichten eine freie Oberfläche $(S_L)$ aufweist, und dass der Sensor (1) ein erstes und ein zweites wärmeleitendes Element (7a, 7b) aufweist, welche sich gegenüber und beabstandet von der freien Oberfläche $(S_L)$ sowie in der Verlängerung der heißen Seite bzw. der kalten Seite der Einheit (E) erstrecken.

**12.** Sensor (1) nach einem der Ansprüche 1 bis 11, **dadurch gekennzeichnet, dass** dieser eine dielektrische Schicht aufweist, die zwischen dem Substrat (3) und der Einheit (E) aus thermoelektrischen Schichten eingesetzt ist.

**Claims**

**1.** Differential temperature sensor (1) between a hot source (Sc) and a cold source (Sf), the sensor (1) comprising:

- a substrate (3),
- an assembly (E) of thermoelectric layers arranged on the substrate (3), the assembly (E) comprising at least one first junction of a thermocouple (100, 101) on one side of the assembly (E), called hot side, and at least one second junction of the thermocouple (100, 101) on the opposite side of the assembly (E), called cold side,
- at least one first and one second connection pads (50, 51) arranged to transfer heat respectively to each first junction and to each second junction,
- a thermally-insulating support member (2) arranged to support the substrate (3), the support member (2) being intended to be connected to the hot source (Sc) and to the cold source (Sf),
- first and second metal connection means arranged to electrically connect the support member (2) respectively to the or each first connection pad (50) and to the or each second connection pad (51), and **characterized in that** the support member (2) comprises heat transfer means arranged to transfer heat from the hot source (Sc) to the first metal connection means, and to transfer heat from the second metal connection means to the cold source (Sf).

**2.** Sensor (1) according to claim 1, **characterized in that** the first and the second connection means comprise a solder bump (20, 21) respectively soldered onto the or each first connection pad (50) and onto the or each second connection pad (51) to assemble the substrate (3) and the support member (2).

**3.** Sensor (1) according to claim 1, **characterized in that** the first and the second connection means comprise a bonding wire (20, 21) respectively welded to the or each first connection pad (50) and to the or each second connection pad (51) to assemble the substrate (3) and the support member (2).

**4.** Sensor (1) according to any of claims 1 to 3, **characterized in that** the heat transfer means comprise at least a first and a second metal connector pins (30, 31) intended to be respectively connected to the hot source (Sc) and to the cold source (Sf).

5. Sensor (1) according to claim 4, **characterized in that** the heat transfer means comprise:

- at least one first metal track (40) connecting the first connection means to the or each first metal connector pin (30),
- at least one second metal track (41) connecting the second connection means to the or each second metal connector pin (31).

6. Sensor (1) according to any of claims 1 to 5, **characterized in that** it comprises an integrated circuit package (6) enclosing the assembly (E) of thermoelectric layers, said package (6) comprising the support member (2).

7. Sensor (1) according to claim 6 in combination with claim 4, **characterized in that** it comprises an additional package (8) enclosing the integrated circuit package (6), the additional package (8) comprising:

- a first surface (8a) and a second opposite surface (8b), preferably coated with a thermally-conductive material, the first and second surfaces (8a, 8b) being intended to be respectively connected to the hot source (Sc) and to the cold source (Sf),
- a first via (80), preferably metallic, connecting the first surface (8a) to each first connector pin (30),
- a second via (81), preferably metallic, connecting the second surface (8b) to each second connector pin (31).

8. Sensor (1) according to claim 7, **characterized in that** the additional package (8) comprises a support member (9) arranged to support the integrated circuit package (6).

9. Sensor (1) according to claim 7 or 8, **characterized in that** the integrated circuit package (6) comprises at least one electric connector pin (32) and **in that** the additional package (8) comprises at least one electric track (90) extending from the electric connector pin (32).

10. Sensor (1) according to any of claims 1 to 5, **characterized in that** it comprises an encapsulation layer (5) arranged on the support member (2) to encapsulate the assembly (E) of thermoelectric layers, the encapsulation layer (5) being preferably made of a material based on a polymer.

11. Sensor (1) according to any of claims 1 to 10, **characterized in that** the assembly (E) of thermoelectric layers has a free surface ($S_L$), and **in that** the sensor (1) comprises a first and a second thermally-conductive elements (7a, 7b) facing said free surface ($S_L$) and extending at a distance from said free surface ($S_L$), and respectively continuing said assembly (E) on the hot side and on the cold side.

12. Sensor (1) according to any of claims 1 to 11, **characterized in that** it comprises a dielectric layer interposed between the substrate (3) and the assembly (E) of thermoelectric layers.

Fig. 1

Fig. 2

Fig. 3

*Fig. 4*

*Fig. 5*

*Fig. 6*

*Fig. 7*

Fig. 8

Fig. 9

Fig. 10

Fig. 11

Fig. 12

Fig. 13

Fig. 14

**Fig. 15**

**Fig. 16**

## RÉFÉRENCES CITÉES DANS LA DESCRIPTION

**Documents brevets cités dans la description**

- WO 2013007593 A
- WO 2007034048 A
- FR 2955708
- WO 8402037 A
- FR 2598803
- WO 2011012586 A